# EUROPEAN PATENT SPECIFICATION

(11) **EP 3 929 615 B1**
(45) Date of publication and mention of the grant of the patent: **08.05.2024**
(21) Application number: 21168314.9
(22) Date of filing: 14.04.2021
(51) Int. Cl.: G01S 7/481, G01S 7/4863, G01S 17/894

(54) **THREE-DIMENSIONAL IMAGING METHOD BASED ON SUPERCONDUCTING NANOWIRE PHOTON DETECTION ARRAY**
DREIDIMENSIONALES ABBILDUNGSVERFAHREN BASIEREND AUF EINEM SUPRALEITENDEN NANODRAHT-PHOTONEN-DETEKTIONSARRAY
PROCÉDÉ D'IMAGERIE TRIDIMENSIONNELLE À BASE DE RÉSEAU DE DÉTECTION DE PHOTONS À NANOFILS SUPRACONDUCTEURS

(30) Priority: 28.06.2020 CN 202010595694
(43) Date of publication of application: 29.12.2021
(73) Proprietor: Nanjing University, Nanjing, Jiangsu 210046 (CN)
(72) Inventor: ZHANG, Labao, Nanjing, 210023 (CN); YIN, Rui, Nanjing, 210023 (CN); ZHANG, Biao, Nanjing, 210023 (CN); GUO, Shuya, Nanjing, 210023 (CN); TAN, Jingrou, Nanjing, 210023 (CN); GE, Rui, Nanjing, 210023 (CN); KANG, Lin, Nanjing, 210023 (CN); WU, Peiheng, Nanjing, 210023 (CN)
(74) Representative: Murgitroyd & Company

(56) References cited:
- CN-A- 109 357 774
- ZHAO QING-YUAN ET AL: "Single-photon imager based on a superconducting nanowire delay line", NATURE PHOTONICS, vol. 11, no. 4, 27 March 2017 (2017-03-27) , pages 247-251, XP055849018, UK ISSN: 1749-4885, DOI: 10.1038/nphoton.2017.35

## Description

### TECHNICAL FIELD

The present invention belongs to the technical field of superconducting nanowire photon detection, and particularly relates to an array imaging technology.

### BACKGROUND

A superconducting nanowire single photon detector (SNSPD), a novel single photon detector, is applied to the fields of quantum information, space communication, laser radar, spectrum detection, time flight, depth imaging and the like, has the advantages of high sensitivity, low noise, low dark counting, low time jitter and the like.

SNSPD adopts a nanowire prepared from an ultrathin superconducting material, forms a local hot-spot by absorbing photons, and generates voltage pulse signals at two ends of the nanowire to realize single photon detection. A bias current I_{b} is applied to the nanowire in the superconducting state, and a "hot-spot" is locally formed after the nanowire absorbs photons; the density of the current around the "hot-spot" exceeds superconducting critical current density, the partial resistance is increased, so that the current of the nanowire is reduced, and meanwhile, the joule heat effect of a resistance area is weakened to dissipate heat to surrounding environment; the temperature of the resistance area is gradually reduced to the ambient temperature, the resistance area disappears, and the current of the nanowire is recovered to the initial state.

The formation of electrical pulses reflects the process that the current of the nanowire I_{D} changes along with time, and if an external bias current I_{b} is constant, the SNSPD is equivalent to a dynamic inductor Lₖ, a switch S and a time-varying resistor Rn. When the SNSPD does not generate photon responses, the nanowire is in a superconducting state, S is closed, current passes through the nanowire to ground, I_{L} = 0, and I_{D} = I_{B}; after the nanowire absorbs photons, S is opened to form the resistor Rn, and according to the current continuity theorem, I_{L} + I_{D} = I_{B}, I_{D} is rapidly reduced, and I_{L} is rapidly increased; due to the existence of an electrothermal feedback mechanism in the nanowire, the nanowire is recovered to a superconducting state after tens of nanoseconds, and S is closed.

The detection efficiency of a single SNSPD is higher than that of a semiconductor avalanche photodiode (APD), but the single SNSPD can only represent whether photons are absorbed or not and cannot accurately output a number and spatial position distribution of the photons. By encoding the spatial position of the photons, the information which can be represented by the single photon can be further increased, but a detection area of the SNSPD is increased, and the dynamic inductance of the detector is increased at the same time, which influences the speed of the detector.

The large-scale superconducting nanowire single-photon detector array is used to make the size of a single picture element to be as small as possible, and a large-area single photon detection is achieved through a plurality of pixels; however, at present, it is still difficult to form a large-scale array by a plurality of SNSPDs and read the same.

A conventional imaging system digitizes an analog signal, processes the digital signal, and restores the digital signal into an original image. Two methods for digitizing weak signals are common. In the first method, weak current signals are converted and amplified into voltage signals in real time, that is, I-V conversion is performed, then analog voltage signals are converted into digital signals by A/D conversion, signals outputted by a detector are completely restored, and carriers in a common semiconductor radio frequency amplifier do not migrate and lose amplification effect under a condition of superconducting low temperature. The second method is a time period processing method, a current-voltage real-time conversion or integral circuit is adopted at the front end to convert current into a voltage signal, then the voltage signal is converted into pulses by a circuit such as a V-F conversion or a comparator, a single pulse represents fixed charge quantity, and the total charge quantity is in direct proportion to the number of the pulses.

CN109357774 A discloses a superconducting photon camera.

"Single-photon imager based on a superconducting nanowire delay line" by Zhao, Quing-Yuan et al., Nature Photonics, volume 11, no. 4, pages 247-251 (2017), discloses a scalable single-photon imager using a single continuous superconducting nanowire that is a single-photon detector and also functions as a microwave delay line.

### SUMMARY

The present invention provides a three-dimensional imaging method according to claim 1. The method is based on a superconducting nanowire photon detection array, converts outputted pulse signals into current signals, integrates the current signals within a period of time, then converts the current signals into pulse output, inverts a number of pulses according to the direct-proportion relation between the total charge quantity and the number of outputted pulses, has a working wave band of 750 nm to 1550 nm and has the highest photon detection efficiency of 98%.

The array element comprises a superconducting nanowire circuit, an amplifying circuit, a converting circuit, an integrating circuit and a buffer, wherein the superconducting nanowire circuit is connected with an input end of the amplifying circuit, an output end of the amplifying circuit is connected with an input end of the integrating circuit through the converting circuit, and an output end of the integrating circuit is connected with a computer through the buffer.

The superconducting nanowire circuit is located at a center of the array element, and is connected with coplanar superconducting delay lines by connecting the superconducting nanowires and a thin film resistor in parallel; each row of the superconducting delay lines are connected with each other, the thin film resistor has a resistance value of 10 Ω to 10000 Ω, and the resistance generated by superconducting nanowire photon responses is in the order of kΩ to MΩ; the thin film resistor short-circuits the resistance generated by the nanowire, and releases temporary resistance generated by internal superconducting disturbance, so that the nanowire is quickly restored to a superconducting state.

The amplifying circuit comprises a biasing circuit, a first stage amplifying circuit, a second stage amplifying circuit and a compensating circuit, wherein the first-stage amplification circuit adopts differential input, and the second-stage amplification circuit adopts a common-source amplifier; the compensating circuit consists of an MOS transistor and a capacitor, the MOS transistor works in a linear region and provides a constant bias current; and resistance is added into the biasing circuit by a source of the MOS transistor, and each array element shares a constant current source to generate a stable current.

The converting circuit adopts a comparator and an MOS transistor, an input voltage is connected to a non-inverting input end of the comparator, a reference voltage is connected to an inverting input end of the comparator, an output end of the comparator is connected to a gate of the MOS transistor through a pull-up resistor, a drain of the MOS transistor is used as an output current, and if the input voltage is higher than the reference voltage, the MOS transistor conducts the output current.

The integrating circuit adopts an MOS transistor and a capacitor, and an input current charges the capacitor through the MOS transistor to realize integration; and the circuit is reset to a low potential before integrating, and forced reset by a switch or reset by an MOS transistor is adopted.

The nanowire circuit is biased in a state slightly lower than a superconducting critical current of the nanowire at the superconducting low temperature; the nanowire absorbs photons at the superconducting low temperature, the superconducting state of an absorption area is damaged, a "hot-spot" occurs, a resistor is generated and is connected with the thin film resistor in parallel, and the resistance value is changed; the nanowire is cooled, the "hot-spot" disappears, the nanowire is restored to the initial state, and the resistance value is changed; the changes of the resistance value of the nanowire enables the circuit to generate electrical pulse signals, and the electrical pulse signals are amplified by the amplifying circuit through the superconducting delay lines; the voltage signals are converted into current signals by the converting circuit, and charge quantity of the current signals is obtained as the charge quantity of absorbed photons by the integrating circuit; and the charge quantity of absorbed photons is stored in the buffer, inputted into the computer by rows, and compared with charge quantity of single photon to obtain the number of the absorbed photons.

A picture element position of a nanowire for generating photon responses is set as xₐ, a time point for absorbing photons as tₐ, a transmission speed of electrical pulse signals generated by the picture element along the nanowire as v, time read by the computer are τ and τ' after the delay through a peripheral circuit and a register, wherein each row of detector delay lines have an equivalent length of L, thus τ = tₐ + (L - xₐ)/v and τ' = tₐ + xₐ/v, and after photons are absorbed, xₐ = ((τ - τ')v + L)/2 and tₐ = ((τ + τ') - L/v)/2; and n pixels in each row simultaneously generating the photon responses are set, wherein the reading time is τ₁, τ₂, ··,τₙ, and positions of the photon responses are calculated and obtained.

The pulsed laser is used to record total round-trip time of each photon τₐₗₗ, a distance between the actual position of the object and the pixel points is calculated according to 1 = c*τₐₗₗ/2, where c is light speed in free space.

The present invention not only has single photon detection function, but also can obtain the photon information reflected or directly emitted by a surface of the object, and restores the original photon resolution information of the object by an algorithm, thereby realizing the identification of a target distance and a three-dimensional image.

### BRIEF DESCRIPTION OF DRAWINGS

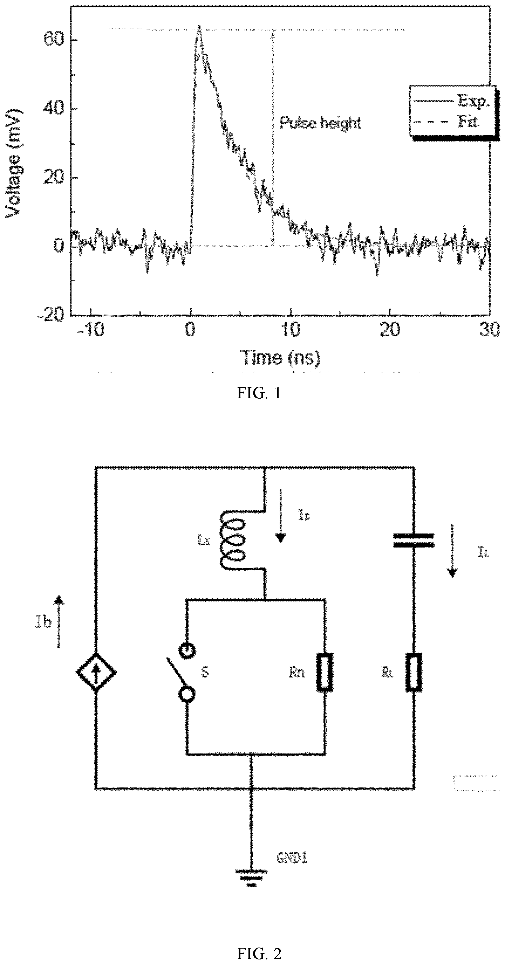

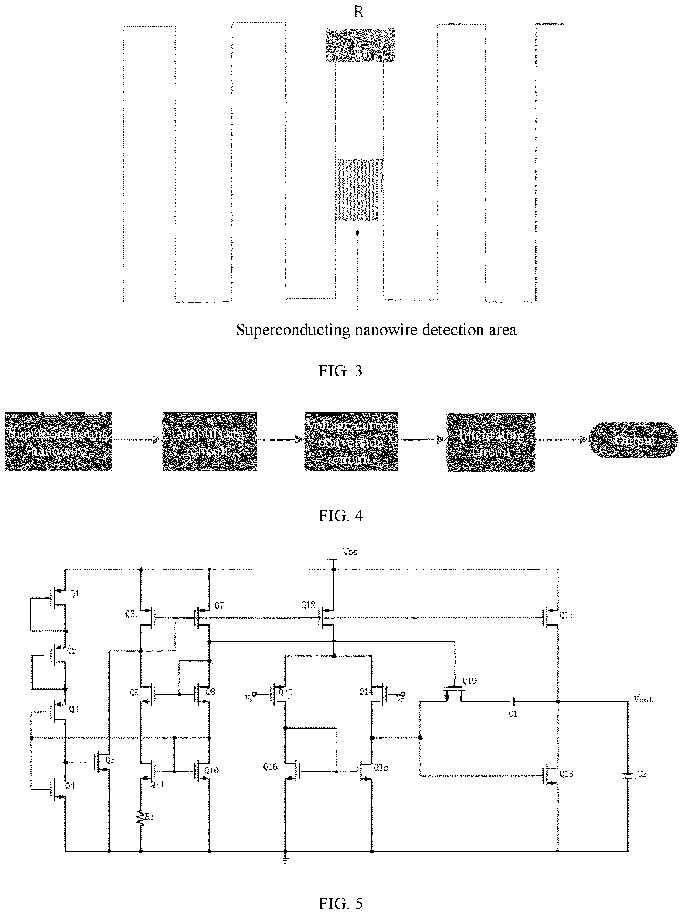

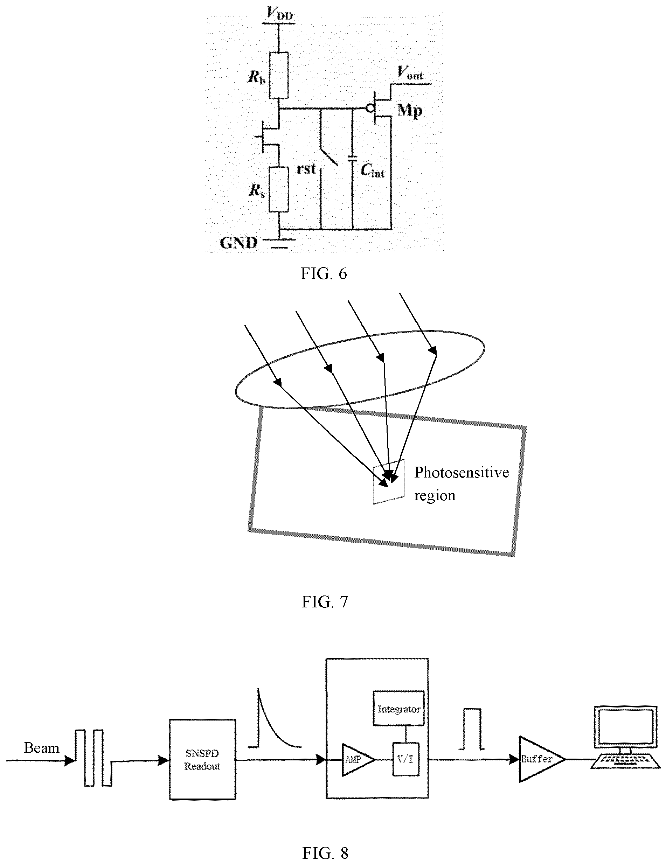

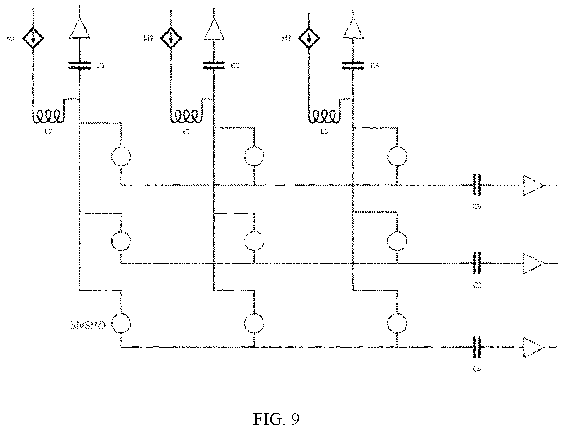

FIG. 1 is voltage pulse signals, FIG. 2 is an equivalent circuit of an pulse response, FIG. 3 is a nanowire and resistor structure, FIG. 4 is an integration imaging process, FIG. 5 is a two-stage amplifying circuit, FIG. 6 is an integrating circuit, FIG. 7 is a lens condensing process, FIG. 8 is a picture element processing process, and FIG. 9 is an array circuit principle.

### DETAILED DESCRIPTION OF EMBODIMENTS

The technical solutions of the present invention are described in detail below with reference to the drawings.

SNSPD adopts a nanowire prepared from an ultrathin superconducting material, forms a local hot-spot by absorbing photons, and generates voltage pulse signals at two ends of the nanowire (as shown in FIG. 1) to realize single photon detection.

It can be seen from the formation of the electrical pulse that an external bias current I_{b} is constant, the SNSPD is equivalent to a dynamic inductor Lₖ, a switch S and a time-varying resistor Rn, and the whole process is shown in FIG. 2 under the action of an external circuit.

When the SNSPD does not generate photon responses, the nanowire is in a superconducting state, S is closed, current passes through the nanowire to ground, I_{L} = 0, and I_{D} = I_{B}; after the nanowire absorbs photons, S is opened to form the resistor Rn, and according to the current continuity theorem, I_{L} + I_{D} = I_{B}, I_{D} is rapidly reduced, and I_{L} is rapidly increased; due to the existence of an electrothermal feedback mechanism in the nanowire, the nanowire is recovered to a superconducting state after hundreds of picoseconds, and S is closed.

Superconducting nanowire single photon detectors (SNSPDs) are provided as array elements to form an array, and incident photons are detected; array elements are taken as picture elements, voltage pulse signals outputted by each picture element are amplified, and the voltage signals are converted into current signals by providing an MOS transistor; an integrating capacitor is adopted, the charge quantity is obtained by current signal integration, and a number of photons are calculated according to the charge quantity of the picture elements; the gray scale of each picture element is defined according to the number of photon number of each pixel in the array, the gray scale image of the array element is generated, and the gray scale image is converted into an original image.

In the center of a single picture element, a parallel structure formed by a superconducting nanowire and a thin film resistor is adopted, as shown in FIG. 3, two ends of the superconducting nanowire and the thin film resistor are connected with a coplanar superconducting delay transmission line and used as an input end of a two-stage amplifying circuit, an output end of the amplifying circuit is connected with a base of a triode, and an emitter of the triode is connected with an integrating circuit.

The working principle of the integration imaging circuit is shown in FIG. 4. The circuit is biased in a state slightly lower than the superconducting critical current of the nanowire when the picture elements are at a superconducting low temperature; the superconducting state of an absorption area is damaged after the nanowire absorbs photons, a "hot-spot" appears, and resistance is generated, and at this time, the superconducting nanowire and the resistor are considered to be connected in parallel, so that the resistance value of the whole circuit is changed; with the cooling of the nanowire and the substrate, the "hot-spot" disappears and the nanowire is recovered to an initial state; the process is represented as electrical pulse signals on an external circuit, the electrical pulse signals are amplified by a two-stage amplifying circuit with a superconducting delay line, and voltage signals are converted into current signals by an MOS transistor; and the current signals are integrated to obtain the charge on the picture element, and the number of photons of the picture element is calculated and obtained according to the charge quantity of a single pulse.

The resistor in the picture element circuit is made of metal materials or other resistance materials and the resistance value is 10 S2 to 10000 Ω. After superconducting nanowire photon responses, the nanowire resistor is changed from a superconducting state to a resistance state, the resistance is in the order of kΩ to MΩ; at this time, the nanowire is in short circuit connection with the resistance, the resistance plays a good shunting role, a temporary resistance state formed by superconducting disturbance inside the nanowire is released, the nanowire is prevented from being in a latch state, the superconducting current of the nanowire is improved, the current reduce time of the nanowire is shortened, and the nanowire is enabled to be rapidly recovered to the superconducting state.

As shown in FIG. 5, the two-stage amplifying circuit mainly comprises four parts: a biasing circuit, a first stage amplifying circuit, a second stage amplifying circuit and a compensating circuit; wherein the first-stage amplifying circuit adopts differential input, so that common-mode signal interference is effectively suppressed; the second-stage amplifying circuit adopts a common-source amplifier, a constant bias current is provided by an MOS transistor, the MOS transistor Q₁₉ works in a linear region and is equivalent to a resistor, and Q₁₉ and C₁ form a Miller compensation circuit; a resistor R is added to the source of an MOS transistor in the bias circuit, and a stable current source I_{B} is generated in a branch circuit.

A voltage/current conversion circuit is realized by a field effect transistor, an SNSPD array in the circuit works at extremely low temperature, a common semiconductor amplifier cannot work normally, and the field effect transistor is a voltage control device and controls a drain to output current I_{D} through gate voltage V_{GS}; voltage outputted by a front end circuit is connected to a non-inverting input end of a comparator, reference voltage is connected to an inverting input end of a comparator, an output end of the comparator is connected to the G pin through a pull-up resistor, and if the voltage outputted by the front end circuit is controlled to be higher than the reference voltage, the MOS transistor conducts the output current.

As shown in FIG. 6, the integrating circuit is composed of a PMOS transistor and an integrating capacitor, and the current outputted by the front-end circuit is charged to the integrating capacitor through an injection transistor to realize integration; the gain of the circuit is mainly related to the size of the capacitor and is also limited by the voltage of the power supply, the circuit is reset to a low potential before integration, and the circuit adopts a switch to reset forcibly and can also reset by providing an MOS transistor.

The signals outputted by each picture element are collected to a buffer, a number of photons of picture element (i.e., pixel point) is calculated by a coefficient of which charge quantity is in direct proportion to the number of photons, and for a large array detector, the larger the array is, the more the picture elements are, the higher the pixels are, and the higher the image restoration is.

By providing a special photon alignment system, as shown in FIG. 7, a lens array splits incident lights into a plurality of beams with the same number as that of picture elements, and the plurality of beams are converged to a superconducting nanowire detection area, so that the filling rate of the array device is improved.

The picture element structure is shown in FIG. 8, the picture element array is shown in FIG. 9 and is formed by arranging a plurality of picture elements, and each picture element in the array is provided with a single nanowire, a signal processing circuit and an integrating circuit; each column is connected with a constant current source to provide a bias current for the superconducting nanowires; the output end of each row of picture elements is connected with a buffer for a computer to read data, and the picture elements in each row are connected with each other by superconducting delay lines.

A photon detection is performed on a surface of an object, and different photon pulse signals reflected by the surface of the object are emitted into a picture element detection area of an integral imaging device through the lens array.

Assuming that all picture elements in the array simultaneously respond to photons and generate electrical pulse signals, electrical pulse signals of each picture element are integrated in a period using a time sequence circuit, output voltages are transmitted into a buffer, and the signals are read into a computer by rows; the longer the integration period is, the more photons the detector array detects each period, but the much longer the integration period is, the much more photons are, which results in the integrated signal being too large to be processed, so an integration period should be chosen appropriately.

After a photon is absorbed by a superconducting nanowire, assuming that the position of a picture element generating response on the nanowire is xₐ, the time point of photon absorption is tₐ, an electrical pulse signal is generated at the position of the picture element, the electrical pulse signal is processed by a peripheral circuit of the picture element, a voltage V₀ is outputted to a register Rₐ, the electrical pulse signal is transmitted to the other end of the nanowire at a fixed speed v, the time read by a computer is τ and τ' after subtracting fixed delays such as access transmission time and reading delay time of electrical pulse in the peripheral circuit and the register; and assuming that each row of detector delay lines have an equivalent length of L, based on a relationship between distance, time and speed, it can be concluded that τ = tₐ + (L - xₐ)/v and τ' = tₐ + xₐ/v, and the relationship between the position xₐ of the picture element and the time tₐ is xₐ = ((τ-τ')v + L)/2 and tₐ = ((τ + τ') - L/v)/2 after photon absorption.

When n pixels in the same row generate photon response at the same time, the position of the photon response is determined according to the time τ₁, τ₂, ··,τₙ of reading picture elements; after a fixed time T, according to direct proportion of charge quantity to a number of photons, the voltage signal received by each picture element (pixel point) is restored to the number of photons to generate a statistical graph with gray scale, and when the superposition times are enough, the gray scale graph can reflect specific photon information of the identified object.

The pulsed laser is used to record total round-trip time of each photon τₐₗₗ, a distance between the actual position of the object and the pixel points is calculated according to 1 = c*τₐₗₗ/2, where c is light speed in free space. A three-dimensional image of an object can be reconstructed after obtaining spatial position information of the object.

## Claims

1. A three-dimensional imaging method based on a superconducting nanowire photon detection array, the method comprising:
providing superconducting nanowire single-photon detectors, SNSPDs, as array elements to form a superconducting nanowire photon detection array, placing the array elements at a superconducting low temperature, and biasing the array elements to be in a state slightly lower than a superconducting critical current of the array elements;
providing a lens array as an optical alignment system, and splitting light generated by a pulsed laser into a plurality of beams with the same number as that of the array elements;
irradiating the surface of an object with the plurality of beams, receiving light beams reflected by the surface of the object through the lens array and converging the plurality of reflected light beams to the superconducting nanowire photon detection array to generate voltage pulse signals;
converting the voltage pulse signals into current pulse signals;
recording a round-trip time of each photon;
integrating current pulse signals outputted by the array elements over a period of time to obtain a total integrated charge, obtaining a number of photons absorbed by the array elements by a corresponding relation between the total integrated charge and the number of photons;
calculating gray values of picture elements based on the number of photons absorbed by the array elements; and
plotting a gray-scale image by taking the array elements as pixel points of the grayscale image, calculating a distance between the object and the pixel points according to the round-trip time of each photon, and reconstructing a three-dimensional image of the object according to the gray-scale image and the distance between the object and the pixel points.

2. The three-dimensional imaging method according to claim 1, wherein an array element of the array elements comprises a superconducting nanowire circuit, an amplifying circuit, a converting circuit, an integrating circuit and a buffer; and the superconducting nanowire circuit is connected with an input end of the amplifying circuit, an output end of the amplifying circuit is connected with an input end of the integrating circuit through the converting circuit, and an output end of the integrating circuit is connected with a computer through the buffer.

3. The three-dimensional imaging method according to claim 2, wherein the step of collecting a number of photons detected by each array element comprises: allowing the nanowire to absorb photons and inflicting a damage on a superconducting state of an absorption area, then resulting in a "hot-spot", and leading to changes in a resistance value; the nanowire dissipates heat to the surrounding environment, resulting in the disappearance of the "hot-spot", allowing the nanowire to restore to an initial state, and leading to changes in the resistance value; enabling the circuit to generate electrical pulse signals by the changes of the resistance value of the nanowire, and amplifying the electrical pulse signals by the amplifying circuit through superconducting delay lines; converting voltage signals into current signals by the converting circuit, and obtaining the amount of charge in current signals as charge on the absorbed photons by the integrating circuit; and storing the charge on the absorbed photons in the buffer and inputting the charge on the absorbed photons into the computer by rows, and comparing the charge on the absorbed photons with charge on single photon to obtain the number of the absorbed photons.

4. The three-dimensional imaging method according to claim 2, wherein the superconducting nanowire circuit is located at a center of the array element, and is connected with coplanar superconducting delay lines by connecting the superconducting nanowires and a thin film resistor in parallel; each row of the superconducting delay lines are connected with each other, the thin film resistor has a resistance value of 10 S2 to 10000 Ω, and the resistance generated by superconducting nanowire photon responses is in the order of kΩ to MΩ; the thin film resistor short-circuits the resistance generated by the nanowire, and releases a temporary resistance generated by internal superconducting disturbance, so that the nanowire is quickly restored to a superconducting state.

5. The three-dimensional imaging method according to claim 2, wherein the amplifying circuit comprises a first stage amplifying circuit, a second stage amplifying circuit, a compensating circuit and a biasing circuit; the first-stage amplification circuit comprises differential input, and the second-stage amplification circuit comprises a common-source amplifier; the compensating circuit consists of an MOS (Metal-Oxide-Semiconductor) transistor and a capacitor, wherein the MOS transistor works in a linear region and provides a constant bias current; and resistance is added into the biasing circuit by a source of the MOS transistor, and each array element shares a constant current source to generate a stable current.

6. The three-dimensional imaging method according to claim 2, wherein the converting circuit comprises a comparator and an MOS transistor, an input voltage is connected to a non-inverting input end of the comparator, a reference voltage is connected to an inverting input end of the comparator, an output end of the comparator is connected to a gate of the MOS transistor through a pull-up resistor, a drain of the MOS transistor is used as an output current, and if the input voltage is higher than the reference voltage, the MOS transistor conducts the output current.

7. The three-dimensional imaging method according to claim 2, wherein the integrating circuit comprises a MOS transistor and a capacitor, and an input current charges the capacitor through the MOS transistor to realize integration; and the circuit is reset to a low potential before integrating, and forced reset by a switch or reset by an MOS transistor is used.

8. The three-dimensional imaging method according to claim 2, wherein the step of plotting a gray-scale image by taking the picture elements as pixel points comprises: setting a picture element position of a nanowire for generating photon responses as xₐ, a time point for absorbing photons as tₐ, a transmission speed of electrical pulse signals generated by the picture element along the nanowire as v, providing a superconducting nanowire as a delay line to connect a detector of each picture element, and reading time by the computer as τ and τ' after the delay through a peripheral circuit and a register, wherein each row of detector delay lines have an equivalent length of L, thus τ = tₐ + (L - xₐ)/v and τ' = tₐ + xₐ/v, and after photons are absorbed, xₐ = ((τ - τ')v + L)/2 and tₐ = ((τ + τ') - L/v)/2; and setting n pixels in each row simultaneously generating the photon responses, wherein the reading time is τ₁, τ₂, ··,τₙ, and calculating to obtain positions of the photon responses.

9. The three-dimensional imaging method according to claim 2, wherein the step of calculating a distance between the object and the pixel points according to the round-trip time of each photon comprises: setting the round-trip time of the photon as τₐₗₗ and light speed as c, wherein the distance between the object position and the pixel points is calculated according to 1 = c*τₐₗₗ/2.

## Patentansprüche

1. Ein dreidimensionales Abbildungsverfahren, das auf einem supraleitenden Nanodraht-Photonen-Detektionsarray basiert, wobei das Verfahren Folgendes beinhaltet:
Bereitstellen von supraleitenden Nanodraht-Einzelphotonen-Detektoren, SNSPDs, als Arrayelemente, um ein supraleitendes Nanodraht-Photonen-Detektionsarray zu bilden, Anordnen der Arrayelemente bei einer supraleitenden tiefen Temperatur und Vorspannen der Arrayelemente, damit sich diese in einem Zustand leicht unterhalb eines supraleitenden kritischen Stroms der Arrayelemente befinden;
Bereitstellen eines Linsenarrays als ein optisches Ausrichtungssystem und Aufteilen von Licht, das durch einen gepulsten Laser erzeugt wird, in eine Vielzahl von Strahlen mit der gleichen Anzahl wie die der Arrayelemente;
Bestrahlen der Oberfläche eines Objekts mit der Vielzahl von Strahlen, Empfangen von Lichtstrahlen, die durch die Oberfläche des Objekts reflektiert werden, durch das Linsenarray und Konvergieren der Vielzahl von reflektierten Lichtstrahlen zu dem supraleitenden Nanodraht-Photonen-Detektionsarray, um Spannungsimpulssignale zu erzeugen;
Umwandeln der Spannungsimpulssignale in Stromimpulssignale;
Aufzeichnen einer Roundtrip-Zeit jedes Photons;
Integrieren von Stromimpulssignalen, die durch die Arrayelemente über einen Zeitraum ausgegeben werden, um eine integrierte Gesamtladung zu erhalten, Erhalten einer Anzahl von Photonen, die durch die Arrayelemente absorbiert werden, durch eine entsprechende Relation zwischen der integrierten Gesamtladung und der Anzahl von Photonen;
Berechnen von Grauwerten von Bildelementen basierend auf der Anzahl von durch die Arrayelemente absorbierten Photonen; und
Zeichnen eines Graustufenbildes durch das Nehmen der Arrayelemente als Pixelpunkte des Graustufenbildes, Berechnen eines Abstands zwischen dem Objekt und den Pixelpunkten gemäß der Roundtrip-Zeit jedes Photons und Rekonstruieren eines dreidimensionalen Bildes des Objekts gemäß dem Graustufenbild und dem Abstand zwischen dem Objekt und den Pixelpunkten.

2. Dreidimensionales Abbildungsverfahren gemäß Anspruch 1, wobei ein Arrayelement der Arrayelemente eine supraleitende Nanodrahtschaltung, eine Verstärkerschaltung, eine Wandlerschaltung, eine Integratorschaltung und einen Puffer beinhaltet; und die supraleitende Nanodrahtschaltung mit einem Eingangsende der Verstärkerschaltung verbunden ist, ein Ausgangsende der Verstärkerschaltung durch die Wandlerschaltung mit einem Eingangsende der Integratorschaltung verbunden ist und ein Ausgangsende der Integratorschaltung durch den Puffer mit einem Computer verbunden ist.

3. Dreidimensionales Abbildungsverfahren gemäß Anspruch 2, wobei der Schritt des Sammelns einer Anzahl von Photonen, die durch jedes Arrayelement detektiert werden, Folgendes beinhaltet: Ermöglichen, dass der Nanodraht Photonen absorbiert, und Verursachen eines Schadens an einem supraleitenden Zustand eines Absorptionsbereichs, was dann in einem "Hotspot" resultiert und zu Änderungen eines Widerstandswerts führt; der Nanodraht gibt Wärme an die umliegende Umgebung ab, was in dem Verschwinden des "Hotspots" resultiert, was es dem Nanodraht ermöglicht, einen ursprünglichen Zustand wiederzuerlangen, und zu Änderungen des Widerstandswerts führt; Befähigen der Schaltung, durch die Änderungen des Widerstandswerts des Nanodrahts elektrische Impulssignale zu erzeugen, und Verstärken der elektrischen Impulssignale durch die Verstärkerschaltung durch supraleitende Verzögerungsleitungen; Umwandeln von Spannungssignalen in Stromsignale durch die Wandlerschaltung und Erhalten der Menge an Ladung in Stromsignalen als eine Ladung in den absorbierten Photonen durch die Integratorschaltung; und Speichern der Ladung in den absorbierten Photonen in dem Puffer und zeilenweises Eingeben der Ladung in den absorbierten Photonen in den Computer und Vergleichen der Ladung in den absorbierten Photonen mit der Ladung in einem einzelnen Photon, um die Anzahl von absorbierten Photonen zu erhalten.

4. Dreidimensionales Abbildungsverfahren gemäß Anspruch 2, wobei sich die supraleitende Nanodrahtschaltung in einer Mitte des Arrayelements befindet und durch das parallele Verbinden der supraleitenden Nanodrähte und eines Dünnschichtwiderstandelements mit komplanaren supraleitenden Verzögerungsleitungen verbunden ist; wobei alle Zeilen der supraleitenden Verzögerungsleitungen miteinander verbunden sind, das Dünnschichtwiderstandselement einen Widerstandswert von 10 Ω bis 10000 Ω aufweist und der durch die Antworten der supraleitenden Nanodraht-Photonen erzeugte Widerstand in dem Bereich von kΩ bis MΩ liegt; wobei das Dünnschichtwiderstandselement den durch den Nanodraht erzeugten Widerstand kurzschließt und einen temporären Widerstand, der durch eine interne supraleitende Störung erzeugt wird, aufhebt, sodass der Nanodraht einen supraleitenden Zustand schnell wiedererlangt.

5. Dreidimensionales Abbildungsverfahren gemäß Anspruch 2, wobei die Verstärkerschaltung eine Verstärkerschaltung einer ersten Stufe, eine Verstärkerschaltung einer zweiten Stufe, eine Kompensationsschaltung und eine Vorspannungsschaltung beinhaltet; wobei die Verstärkerschaltung der ersten Stufe einen Differenzeingang beinhaltet und die Verstärkerschaltung der zweiten Stufe einen Common-Source-Verstärker beinhaltet; wobei die Kompensationsschaltung aus einem MOS(Metall-Oxid-Halbleiter)-Transistor und einem Kondensator besteht, wobei der MOS-Transistor in einem linearen Bereich arbeitet und einen konstanten Vorspannungsstrom bereitstellt; und wobei durch eine Source des MOS-Transistors Widerstand zu der Vorspannungsschaltung hinzugefügt wird und sich alle Arrayelemente eine konstante Stromquelle teilen, um einen stabilen Strom zu erzeugen.

6. Dreidimensionales Abbildungsverfahren gemäß Anspruch 2, wobei die Wandlerschaltung einen Komparator und einen MOS-Transistor beinhaltet, eine Eingangsspannung mit einem nicht invertierenden Eingangsende des Komparators verbunden ist, eine Referenzspannung mit einem invertierenden Eingangsende des Komparators verbunden ist, ein Ausgangsende des Komparators über ein Pull-up-Widerstandselement mit einem Gate des MOS-Transistors verbunden ist, ein Drain des MOS-Transistors als ein Ausgangsstrom verwendet wird und, wenn die Eingangsspannung höher als die Referenzspannung ist, der MOS-Transistor den Ausgangsstrom leitet.

7. Dreidimensionales Abbildungsverfahren gemäß Anspruch 2, wobei die Integratorschaltung einen MOS-Transistor und einen Kondensator beinhaltet und ein Eingangsstrom den Kondensator durch den MOS-Transistor lädt, um eine Integration zu realisieren; und wobei die Schaltung vor der Integration auf ein niedriges Potenzial zurückgesetzt wird und ein erzwungener Reset durch einen Schalter oder ein Reset durch einen MOS-Transistor verwendet wird.

8. Dreidimensionales Abbildungsverfahren gemäß Anspruch 2, wobei der Schritt des Zeichnens eines Graustufenbildes durch das Nehmen der Bildelemente als Pixelpunkte Folgendes beinhaltet: Festlegen einer Bildelementposition eines Nanodrahts zur Erzeugung von Photonenantworten als xₐ, eines Zeitpunkts für das Absorbieren von Photonen als tₐ, einer Übertragungsgeschwindigkeit von elektrischen Impulssignalen, die durch das Bildelement erzeugt werden, entlang des Nanodrahts als v, Bereitstellen eines supraleitenden Nanodrahts als eine Verzögerungsleitung, um einen Detektor jedes Bildelements zu verbinden, und Lesen der Zeit durch den Computer als τ und τ' nach der Verzögerung durch eine Peripherieschaltung und ein Register, wobei jede Zeile von Detektorverzögerungsleitungen eine äquivalente Länge L aufweist, sodass τ = tₐ + (L - xₐ)/v und τ' = tₐ + xₐ/v und nach der Absorption von Photonen xₐ = ((τ - τ')v + L)/2 und tₐ = ((τ + τ') - L/v)/2; und Festlegen von n Pixeln in jeder Zeile, die gleichzeitig die Photonenantworten erzeugen, wobei die Lesezeit τ₁, τ₂, • • , τₙ ist, und Berechnen, um Positionen der Photonenantworten zu erhalten.

9. Dreidimensionales Abbildungsverfahren gemäß Anspruch 2, wobei der Schritt des Berechnens eines Abstands zwischen dem Objekt und den Pixelpunkten gemäß der Roundtrip-Zeit jedes Photons Folgendes beinhaltet: Festlegen der Roundtrip-Zeit des Photons als τₐₗₗ und der Lichtgeschwindigkeit als c, wobei der Abstand zwischen der Objektposition und den Pixelpunkten gemäß 1= c*τₐₗₗ/2 berechnet wird.

## Revendications

1. Un procédé d'imagerie tridimensionnelle basé sur un réseau de détection de photons par nanofils supraconducteurs, le procédé comprenant :
fournir des détecteurs de photons uniques par nanofils supraconducteurs, SNSPD (*Superconducting Nanowire Single-Photon Detectors*)*,* comme éléments de réseau afin de former un réseau de détection de photons par nanofils supraconducteurs, placer les éléments de réseau à une température basse supraconductrice, et polariser les éléments de réseau afin qu'ils soient dans un état légèrement inférieur à un courant critique supraconducteur des éléments de réseau ;
fournir un réseau de lentilles comme système d'alignement optique, et fractionner de la lumière générée par un laser pulsé en une pluralité de faisceaux au même nombre que celui des éléments de réseau ;
irradier la surface d'un objet avec la pluralité de faisceaux, recevoir des faisceaux lumineux réfléchis par la surface de l'objet à travers le réseau de lentilles et faire converger la pluralité de faisceaux lumineux réfléchis vers le réseau de détection de photons par nanofils supraconducteurs afin de générer des signaux à impulsions de tension ;
faire converger les signaux à impulsions de tension en signaux à impulsions de courant ;
enregistrer un temps d'aller-retour de chaque photon ;
intégrer des signaux à impulsions de courant sortis par les éléments de réseau sur un laps de temps afin d'obtenir une charge intégrée totale, obtenir un nombre de photons absorbés par les éléments de réseau par une relation de correspondance entre la charge intégrée totale et le nombre de photons ;
calculer des valeurs de gris d'éléments d'image sur la base du nombre de photons absorbés par les éléments de réseau ; et
tracer une image à échelle de gris en prenant les éléments de réseau comme points de pixels de l'image à échelle de gris, calculer une distance entre l'objet et les points de pixels selon le temps d'aller-retour de chaque photon, et reconstruire une image tridimensionnelle de l'objet selon l'image à échelle de gris et la distance entre l'objet et les points de pixels.

2. Le procédé d'imagerie tridimensionnelle selon la revendication 1, où un élément de réseau des éléments de réseau comprend un circuit à nanofils supraconducteurs, un circuit d'amplification, un circuit de conversion, un circuit d'intégration et un tampon ; et le circuit à nanofils supraconducteurs est connecté à une extrémité d'entrée du circuit d'amplification, une extrémité de sortie du circuit d'amplification est connectée à une extrémité d'entrée du circuit d'intégration par le biais du circuit de conversion, et une extrémité de sortie du circuit d'intégration est connectée à un ordinateur par le biais du tampon.

3. Le procédé d'imagerie tridimensionnelle selon la revendication 2, où l'étape consistant à recueillir un nombre de photons détectés par chaque élément de réseau comprend : permettre au nanofil d'absorber des photons et infliger un dommage à un état supraconducteur d'une zone d'absorption, résultant ensuite en un « point chaud », et menant à des changements de valeur de résistance ; le nanofil dissipe de la chaleur vers l'environnement avoisinant, résultant en la disparition du « point chaud », permettant au nanofil d'être restauré à un état initial, et menant à des changements de valeur de résistance ; activer le circuit afin de générer des signaux à impulsions électriques par les changements de la valeur de résistance du nanofil, et amplifier les signaux à impulsions électriques par le circuit d'amplification par le biais de lignes de retard supraconductrices ; convertir des signaux de tension en signaux de courant par le circuit de conversion, et obtenir la quantité de charge dans des signaux de courant comme charge sur les photons absorbés par le circuit d'intégration ; et stocker la charge sur les photons absorbés dans le tampon et entrer la charge sur les photons absorbés dans l'ordinateur par rangées, et comparer la charge sur les photons absorbés à la charge sur photon unique afin d'obtenir le nombre de photons absorbés.

4. Le procédé d'imagerie tridimensionnelle selon la revendication 2, où le circuit à nanofils supraconducteurs est situé au centre de l'élément de réseau, et est connecté à des lignes de retard supraconductrices coplanaires en connectant les nanofils supraconducteurs et une résistance en film mince en parallèle ; toutes les rangées des lignes de retard sont connectées les unes aux autres, la résistance en film mince a une valeur de résistance de 10 Ω à 10 000 Ω, et la résistance générée par des réponses de photons par nanofils supraconducteurs est de l'ordre de kΩ à MΩ ; la résistance en film mince court-circuite la résistance générée par le nanofil, et libère une résistance temporaire générée par perturbation supraconductrice interne, de sorte que le nanofil est rapidement restauré à un état supraconducteur.

5. Le procédé d'imagerie tridimensionnelle selon la revendication 2, où le circuit d'amplification comprend un circuit d'amplification de premier étage, un circuit d'amplification de deuxième étage, un circuit de compensation et un circuit de polarisation ; le circuit d'amplification de premier étage comprend une entrée différentielle, et le circuit d'amplification de deuxième étage comprend un amplificateur à source commune ; le circuit de compensation consiste en un transistor MOS (métal-oxyde semiconducteur) et un condensateur, où le transistor MOS fonctionne dans une région linéaire et fournit un courant de polarisation constant ; et une résistance est ajoutée dans le circuit de polarisation par une source du transistor MOS, et chaque élément de réseau partage une source de courant constant afin de générer un courant stable.

6. Le procédé d'imagerie tridimensionnelle selon la revendication 2, où le circuit de conversion comprend un comparateur et un transistor MOS, une tension d'entrée est connectée à une extrémité d'entrée non inverseuse du comparateur, une tension de référence est connectée à une extrémité d'entrée inverseuse du comparateur, une extrémité de sortie du comparateur est connectée à une grille du transistor MOS par le biais d'une résistance d'excursion haute, un drain du transistor MOS est utilisé comme courant de sortie, et si la tension d'entrée est plus élevée que la tension de référence, le transistor MOS conduit le courant de sortie.

7. Le procédé d'imagerie tridimensionnelle selon la revendication 2, où le circuit d'intégration comprend un transistor MOS et un condensateur, et un courant d'entrée charge le condensateur par le biais du transistor MOS afin de réaliser l'intégration ; et le circuit est réinitialisé à un potentiel bas avant l'intégration, et une réinitialisation forcée par un commutateur ou une réinitialisation par un transistor MOS est utilisée.

8. Le procédé d'imagerie tridimensionnelle selon la revendication 2, où l'étape consistant à tracer une image à échelle de gris en prenant les éléments d'image comme points de pixels comprend : initialiser une position d'élément d'image d'un nanofil afin de générer des réponses de photons commme xₐ, un point temporel pour absorber des photons comme tₐ, une vitesse de transmission de signaux à impulsions électriques générés par l'élément d'image le long du nanofil comme v, fournir un nanofil supraconducteur comme ligne de retard afin de connecter un détecteur de chaque élément d'image, et lire un temps par l'ordinateur comme τ et τ' après le retard par le biais d'un circuit périphérique et d'un registre, où chaque rangée de lignes de retard de détecteur a une longueur équivalente de L, donc τ = tₐ + (L - xₐ)/v et τ' = tₐ + xₐ/v, et après que des photons ont été absorbés, xₐ = ((τ - τ')v + L)/2 et tₐ = ((τ + τ') - L/v)/2 ; et initialiser n pixels dans chaque rangée générant simultanément les réponses de photons, où le temps de lecture est τ₁, τ₂, • • ,τₙ, et calculer afin d'obtenir des positions des réponses de photons.

9. Le procédé d'imagerie tridimensionnelle selon la revendication 2, où l'étape consistant à calculer une distance entre l'objet et les points de pixels selon le temps d'aller-retour de chaque photon comprend : initialiser le temps d'aller-retour du photon comme τₐₗₗ et de la vitesse de la lumière comme c, où la distance entre la position d'objet et les points de pixels est calculée selon 1= c*τₐₗₗ/2.
